# EUROPÄISCHE PATENTANMELDUNG

(11) **EP 1 005 252 A2**
(43) Veröffentlichungstag der Anmeldung: **31.05.2000**
(21) Anmeldenummer: 99119408.5
(22) Anmeldetag: 30.09.1999
(51) Int. Cl.: H04S 7/00, H03G 5/00

(54) **Wiedergabegerät für Audiosignalträger und Verfahren zur Beeinflussung einer Klangcharakteristik eines wiederzugebenden Audiosignals von einem Audiosignalträger**

(30) Priorität: 24.11.1998 DE 19854125
(71) Anmelder: ROBERT BOSCH GMBH, 70442 Stuttgart (DE)
(72) Erfinder: Rychlak, Stefan, 31241 Ilsede (DE)

(57) **Zusammenfassung**

Es werden ein Wiedergabegerät für Audiosignalträger, sowie ein Verfahren zur Beeinflussung der Klangcharakteristik eines wiederzugebenden Audiosignals beschrieben, bei dem in einem Speicher verschiedene Audiosignalträger kennzeichnende Kennungen und den Audiosignalträgern bzw. den gespeicherten Kennungen zugeordneten Klangcharakteristiken gespeichert sind. Mittels einer steuerbaren Klangbeeinflussungseinrichtung, beispielsweise einem Equalizer oder digitalen Signalprozessor, zur Steuerung der Klangcharakteristik des wiederzugebenden Audiosignals werden die wiederzugebenden Audiosignale in Abhängigkeit der den Audiosignalträgern im Speicher zugewiesenen benutzerdefinierten Klangcharakteristika beeinflußt.

Somit ergibt sich die Möglichkeit, automatisch bei Auswahl eines wiederzugebenden Audiosignalträgers diesen mit einer optimal an die Hörgewohnheiten des Benutzers angepaßten Klangcharakteristik wiederzugeben.

## Beschreibung

### Stand der Technik

Die Erfindung geht von einem Wiedergabegerät für Audiosignalträger, insbesondere plattenförmige optische Audiosignalträger, mit einer steuerbaren Klangbeeinflussungseinrichtung, insbesondere Equalizer oder digitaler Signalprozessor, zur Steuerung der Klangcharakteristik eines wiederzugebenden Audiosignals, sowie einem Verfahren zur Beeinflussung einer Klangcharakteristik eines wiederzugebenden Audiosignals von einem Audiosignalträger mittels einer steuerbaren Klangbeeinflussungseinrichtung nach der Gattung der unabhängigen Patentansprüche aus.

Es sind, beispielsweise aus dem Prospekt 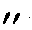 Programm 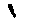 98/'99 - Mobile Kommunikation" der Firma Blaupunkt-Werke GmbH Wiedergabegeräte für Audiosignalträger in Form von Autoradios mit Abspielgeräten für Magnettonbänder, sogenannte Compact-Cassetten (CC), beispielsweise das Gerät vom Typ 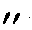 Stockholm RCM 128", oder von optischen plattenförmigen Audiosignalträgern, sogenannten Compact Discs (CD), beispielsweise das Gerät vom Typ 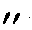 London RDM 126" bekannt. Weiterhin sind aus dem vorgenannten Prospekt auch Autoradiogeräte bekannt, an die ein sogenannter CD-Wechsler, oder auch CD-Changer, zur Wiedergabe des Audiosignals von einer aus einer Mehrzahl von in einem Magazin des CD-Wechslers angeordneten CDs, anschließbar ist. Beispielhaft sei hierfür die Gerätekombination vom Typ 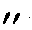 Las Vegas DJ" genannt.

Aus der DE 38 05 457 A1 ist ein Rundfunkempfänger für ein Fahrzeug bekannt, bei dem durch ein senderseitiges Kennsignal bei einer Verkehrsfunksendung die Wiedergabelautstärke auf einen voreingestellten Wert umgeschaltet wird, und der manuelle Einstellmittel für die Tiefen und Höhen aufweist, wobei bei der Umschaltung der Lautstärke zusätzlich durch das Kennsignal eine automatische Umschaltung der Tiefen und Höhen auf voreingestellte Werte erfolgt. Dem liegt die Erkenntnis zugrunde, daß eine für eine Musikwiedergabe als meist angenehm empfundene Anhebung der Tiefen und Höhen bei der Sprachwiedergabe, insbesondere wegen der stark angehobenen Tiefen, im allgemeinen als nachteilig angesehen wird, da die Sprache dann oft zu dumpf klingt und somit unverständlich wird. Durch Umschaltung der Tiefen und Höhen während einer Verkehrsfunkdurchsage auf einen für den jeweiligen Fahrer subjektiv als optimal ermittelten Wert werden Verkehrsdurchsagen für diesen angenehmer und verständlicher.

Weiter werden in der deutschen Patentanmeldung 198 48 491.7 des Anmelders ein Rundfunkempfänger 10 zum Empfang von Radio-Daten, insbesondere ein RDS-Rundfunkempfänger, sowie ein Verfahren zur Beeinflussung einer Klangcharakteristik eines wiederzugebenden Audio-Signals in einem Rundfunkempfänger vorgeschlagen, bei dem in Abhängigkeit einer, beispielsweise mittels des Radio-Daten-Systems übertragenen Programmartkennung, die die Art des Inhalts des empfangenen Rundfunkprogramms, beispielsweise Pop-Musik, Klassische Musik, Sprache, usw., angibt die Klangcharakteristik des wiedergegebenen Audiosignals beeinflußt wird. Dazu werden in einem Speicher abgelegte Klangcharakteristiken für wiederzugebende Audiosignale in Abhängigkeit der Programmartkennung einer Klangbeeinflussungseinrichtung zugewiesen werden, so daß eine automatische Anpassung der Klangcharakteristik eines wiederzugebenden Audio-Signals an die Programmart des über die eingestellte Rundfunksendefrequenz übertragenen Programms ermöglicht wird.

### Vorteile der Erfindung

Das erfindungsgemäße Wiedergabe und das erfindungsgemäße Verfahren mit den Merkmalen der unabhängigen Patentansprüche haben den Vorteil, daß jedem wiederzugebenden Audiosignalträger automatisch eine optimale Klangcharakteristik zugewiesen wird, so daß jeder beliebige Audiosignalträger, ob nun Pop-Musik, klassische Musik oder Sprache ohne Zutun des Benutzers mit einem jeweils, zumindest aus Sicht des Benutzers, optimalen Klangbild wiedergegeben wird.

Unter der Klangcharakteristik sind dabei im Zusammenhang mit der vorliegenden Erfindung zum einen der Frequenzgang des wiederzugebenden Audiosignals, der über eine frequenzbandspezifische Verstärkung des Audiosignals beispielsweise mittels eines Equalizers beeinflußbar ist, zum anderen zusätzliche Klangeffekte, wie beispielsweise Echo- und/oder Hall-Effekte zu verstehen.

Eine besonders einfache Zuordnung einer für einen bestimmten Audiosignalträger vorgesehenen Klangcharakteristik ist dabei dadurch möglich, daß die verschiedenen für die verschiedenen Audiosignalträger vorgesehenen Klangcharakteristiken auf verschiedenen Speicherplätzen innerhalb eines Speichers des erfindungsgemäßen Wiedergabegeräts abgelegt sind, wobei jedem Speicherplatz für eine Klangcharakteristik mindestens ein weiterer Speicherplatz zur Ablage der Kennung eines zugehörigen Audiosignalträgers zugeordnet ist. Auf diese Weise ist durch Vergleich der Kennung eines aktuell wiederzugebenden Audiosignalträgers mit den auf den weiteren Speicherplätzen abgelegten Kennungen eine schnelle Zuordnung einer bestimmten Klangcharakteristik zu dem zugehörigen Audiosignalträger möglich.

Weiter ist es von Vorteil, wenn die für einen bestimmten Audiosignalträger vorgegebene Klangcharakteristik durch einen Benutzer über eine Bedieneinheit des Rundfunkempfängers beeinflußbar ist, da somit die abgespeicherten Klangcharakteristiken optimal an die Hörgewohnheiten beziehungsweise Vorlieben des Benutzers angepaßt werden können.

### Zeichnungen

Ausführungsbeispiele der Erfindung sind in den Zeichnungen dargestellt und werden im folgenden näher erläutert.

Es zeigen
Figur 1 ein Blockschaltbild eines zur Wiedergabe von auf Audiosignalträgern gespeicherten Audiosignalen geeigneten erfindungsgemäßen Wiedergabegeräts 10 im vorliegenden Teil eines Autoradios mit CC- oder CD-Abspielgerät,
Figur 2 schematisch ein Magazin eines an ein Autoradio angeschlossenen CD-Wechslers mit darin eingelegten CDs.

### Beschreibung der Ausführungsbeispiele

Im folgenden werden ein erfindungsgemäßes Wiedergabegerät für auf Audiosignalträgern, oder kurz Tonträgern, gespeicherten Audiosignalen und das erfindungsgemäße Verfahren anhand eines Autoradios mit daran angeschlossenem CD-Wechsler beschrieben, bei dem gemäß einem ersten einfachsten Ausführungsbeispiel in Abhängigkeit einer bestimmten wiederzugebenden CD dem wiederzugebenden Audiosignal eine Klangcharakteristik in Form eines spezifischen Frequenzgangs zugewiesen wird.

Dies bedeutet jedoch nicht, daß die Erfindung auf Autoradiogerät mit daran angeschlossenen CD-Wechslern beschränkt ist, vielmehr erstreckt sich die Erfidung auch auf Autoradios mit integriertem CC- oder CD-Abspielgerät, ebenso wie auf andere Audiosignal-Wiedergabegeräte, wie beispielsweise Audioanlagen für den stationären Betrieb.

Ebenso ist es, wenn auch im folgenden nicht im Detail ausgeführt, im Rahmen der Erfindung vorgesehen, einer bestimmten CD nicht nur einen spezifischen Frequenzgang, sondern auch andere spezifische Klangcharakteristika, wie z. B. Echo- oder Hall-Effekte, als Teil der jeweiligen Klangcharakteristik zuzuordnen.

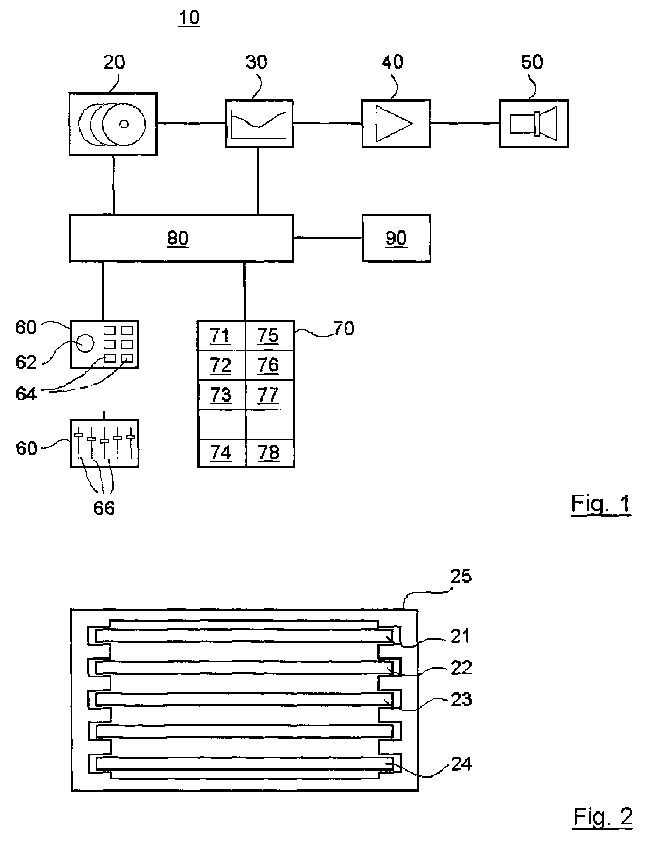

Figur 1 zeigt ein Blockschaltbild des erfindungsgemäßen Wiedergabegeräts am Beispiel eines Autoradios mit angeschlossenem CD-Wechsler zum Betrieb in einem Kraftfahrzeug.

Das erfindungsgemäße Wiedergabegerät 10, hier in Form des vorliegenden Autoradios, verfügt in bekannter Weise über die zur Wiedergabe von Audiosignalen erforderlichen Mittel, wie eine Audiosignalquelle, hier in Form eines CD-Wechslers 10, einen Niederfrequenz- (NF-) Verstärker 40 zur Verstärkung des wiederzugebenden Audiosignals und einen Lautsprecher 50, dem das verstärkte Audiosignal zugeführt ist.

Im Signalpfad zwischen Audiosignalquelle 20 und Niederfrequenzverstärker 40 ist erfindungsgemäß eine Klangbeeinflussungseinrichtung in Form eines Equalizers 30 angeordnet, die das von der Audiosignalquelle, hier also dem CD-Wechsler, abgegebene Audiosignal hinsichtlich seines Frequenzganges in Abhängigkeit von von einer Steuerung 80 zugeführten Parametern beeinflußt. Das hinsichtlich seines Frequenzganges beeinflußte Audiosignal wird schließlich verstärkt und über den Lautsprecher wiedergegeben.

Wenn bisher auch nur von einem einzigen Signalpfad für das Audiosignal die Rede war, und in der Figur auch nur ein einziger Signalpfad dargestellt ist, so erstreckt sich die Erfindung dennoch nicht nur auf monophone Audiosignale, sondern ist auch auf stereophone Audiosignale anwendbar. In diesem Falle wird das von der Audiosignalquelle 20 abgegebene Stereo-Multiplexsignal (MPX), das die Signalanteile für den linken und den rechten Audiokanal enthält, einem im Signalpfad zwischen Audiosignalquelle und Lautsprechern für den linken und den rechten Audiokanal angeordneten Stereodekoder zugeführt, der aus dem MPX-Signal die Signale für den linken und den rechten Kanal herausfiltert.

Beim vorliegenden Ausführungsbeispiel ist es dabei vorgesehen, daß der Stereodekoder im Signalpfad zwischen Audiosignalquelle 20 und Lautsprechern 50 vor der Klangbeeinflussungseinrichtung 30 angeordnet ist, so daß die Klangbeeinflussungseinrichtung Klangbeeinflussungsmittel für jeden der beiden Stereo-Audiokanäle umfaßt.

Die erwähnte Steuerung 80 des erfindungsgemäßen Rundfunkempfängers ist mit einem Ausgang des CD-Wechslers verbunden, an dem Informationen über den Inhalt der jeweils abzuspielenden CD abnehmbar sind. Im vorliegenden Fall handelt es sich dabei um das Inhaltsverzeichnis, das sogenannte 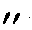 Table Of Contents" (TOC), der CD, das auf dieser abgespeichert ist, und dem Informationen über die Anzahl der auf der CD gespeicherten Musikstücke, sowie deren Länge zu entnehmen sind.

Anhand des Inhaltsverzeichnisses (TOC) einer CD ist diese in der Regel aus einer großen Menge von CDs eindeutig dadurch zu identifizieren, daß in der Regel keine CD mit einer anderen hinsichtlich der TOC-Informationen vollständig übereinstimmt.

Die Steuerung 80 des erfindungsgemäßen Wiedergabegeräts bzw. Autoradios 10 steht mit einem Speicher 70 in Verbindung, der über erste Speicherplätze 71, 72, 73, 74 zum Abspeichern von bestimmte CDs aus einer Menge von CDs kennzeichnenden Kennungen verfügt. Im einfachsten Fall handelt es sich bei den auf den ersten Speicherplätzen 71 bis 74 speicherbaren Kennungen um den TOC der jeweiligen CD oder um aus dem TOC abgeleitete Informationen. Weiterhin weist der Speicher 70 weitere Speicherplätze 75, 76, 77, 78 auf, die den ersten Speicherplätzen 71 bis 74 für die CD-Kennungen zugeordnet sind. In den weiteren Speicherplätzen 75 bis 78 sind Klangcharakteristiken zur Beeinflussung der wiederzugebenden Audiosignale abgelegt.

Im einfachsten Fall, in dem die Klangbeeinflussungseinrichtung 30 in Form eines Equalizers realisiert ist, sind auf den weiteren Speicherplätzen 75 bis 78 Frequenzgänge in Form von Koeffizienten für ein digitales Filter abgespeichert. Alternativ kann es jedoch auch vorgesehen sein, daß die Frequenzgänge in Form von markanten Stützstellen auf den weiteren Speicherplätzen 75 bis 78 des Speichers 70 abgelegt werden.

Wie erwähnt, ist jedem der ersten Speicherplatze 71 bis 74, das heißt jeder abgespeicherten Kennung für einen Audiosignalträger jeweils ein Frequenzgang auf einem der weiteren Speicherplätze 75 bis 78 zugeordnet, der für die Wiedergabe eines durch die zugeordnete Kennung gekennzeichneten Audiosignals als ideal angesehen wird. Dabei ist es durchaus möglich, daß zwei verschiedenen Audiosignalträger-Kennungen, beispielsweise zwei Pop-Musik-CDs, derselbe Frequenzgang zugeordnet ist, so daß eine Abspeicherung zweier getrennter, letztendlich identischer Frequenzgänge, für zwei CDs vergleichbaren Inhalts entbehrlich ist.

Während beim vorliegenden Ausführungsbeispiel der abgespeicherte Frequenzgang für Audiosignalträger mit klassischer Musik, beispielsweise auf dem ersten (75) der weiteren Speicherplätze einen linearen Verlauf aufweist, ist einem Audiosignalträger mit Pop-Musik ein davon abweichender Frequenzgang auf dem weiteren Speicherplatz (76) zugeordnet, der sich dadurch auszeichnet, daß die hoch- und niederfrequenten Signalanteile gegenüber dem mittleren Frequenzbereich verstärkt wiedergegeben werden.

Die Steuerung 80 des erfindungsgemäßen Wiedergabegeräts 10 steht außerdem mit der Klangbeeinflussungseinrichtung 30 zur Steuerung derselben in Verbindung. Der Steuerung 80 kommt dabei die Aufgabe zu, in Abhängigkeit des jeweils abzuspielenden bzw. wiederzugebenden Audiosignalträgers der Klangbeeinflussungseinrichtung 30 einen dem Audiosignalträger zugeordneten Frequenzgang zuzuweisen.

Die Klangbeeinflussungseinrichtung 30 ist dabei im vorliegenden Fall in Form jeweils eines zur Beeinflussung der Frequenzgänge der beiden Stereokanäle geeigneten digitalen Filters ausgeführt. Zur Zuweisung eines auf einem der Speicherplätze 75 bis 78 des Speichers 70 abgelegten Frequenzgänge werden dazu der Klangbeeinflussungseinrichtung 30 beziehungsweise den digitalen Filtern die auf dem jeweiligen Speicherplatz 75 bis 78 abgelegten Filterkoeffizienten mittels der Steuerung 80 zugeführt.

Schließlich ist an die Steuerung 80 des erfindungsgemäßen Rundfunkempfängers 10 eine Eingabeeinheit 60 mit in der Zeichnung in Form eines Drehstellers 62 und Drucktasten 64, bzw. bei einem anderen Ausführungsbeispiel in Form von Schiebereglern 66, dargestellten Bedienelementen angeschlossen.

Im Hinblick auf die vorliegende Erfindung ist die Eingabeeinheit 60 zur Eingabe eines benutzerdefinierten Frequenzganges in Form von frequenzbandspezifischen Verstärkungsfaktoren mittels der dargestellten Bedienelemente vorgesehen, wobei zu einer von einem wiederzugebenden Tonträger am Ausgang des CD-Wechslers anstehenden Kennung ein vom Benutzer über die Bedieneinheit 60 eingegebener benutzerdefinierter Frequenzgang durch die Steuerung 80 des Rundfunkempfängers in den weiteren Speicherplatz 75, 76, 77, 78 des Speichers 70 eingeschrieben wird, der der am Ausgang des CD-Wechslers anstehenden Tonträger-Kennung zugeordnet ist.

Zur Eingabe von benutzerdefinierten Frequenzgängen verfügt die Eingabeeinheit 60 gemäß einem Ausführungsbeispiel eines erfindungsgemäßen Wiedergabegeräts 10 über den verschiedenen beeinflußbaren Frequenzbändern zugeordnete Schieberegler 66, durch deren gezielte Betätigung durch den Benutzer ein Frequenzgang an der Eingabeeinheit 60 einstellbar ist. Die Steuerung 80 ist für diesen Fall so ausgebildet, daß die mittels der Schieberegler verstellten Verstärkungsfaktoren bei den Mittenfrequenzen der beeinflussbaren Frequenzbänder, bei beispielsweise neun unabhängig voneinander beeinflußbaren Frequenzbändern sind das beispielsweise die Mittenfrequenzen 40 Hz, 120 Hz, 250 Hz, 500 Hz, 1KHz, 2 KHz, 4 KHz, 8 KHz, 16 KHz, in Koeffizienten für die digitalen Filter der Klangbeeinflussungseinrichtung 30 umgerechnet werden. Die berechneten Koeffizienten werden darauf auf einem der Speicherplätze 75 bis 78 des Speichers 70 abgelegt.

Bei einem weiteren Ausführungsbeispiel eines erfindungsgemäßen Wiedergabegeräts 10 umfaßt die Eingabeeinheit 60 Drucktasten 64 zur Auswahl eines zu verstellenden Frequenzbandes, sowie einen Drehsteller 62 oder eine Wipptaste zur Verstellung des Verstärkungswertes für das jeweils ausgewählte Frequenzband. Nach erneuter Betätigung der Auswahltaste für das ausgewählte Frequenzband nach Verstellung des Verstärkungswertes, oder aber auch nach Ablauf einer vorgegebenen Zeitdauer nach einer letztmaligen Betätigung der Wipp-Taste beziehungsweise des Drehstellers wird der eingestellte Verstärkungswert von der Steuerung übernommen und aufgrund des verstellten Wertes ein neuer Koeffizientensatz berechnet, der anschließend im Speicher 70 abgelegt wird.

Bei einer weiteren Ausführungsform des erfindungsgemäßen Wiedergabegeräts ist die Klangbeeinflussungseinrichtung 30 in Form eines analogen Equalizers ausgeführt, das heißt die Klangbeeinflussungseinrichtung 30 verfügt über eine Vielzahl von beispielsweise 5 analogen Bandpässen, deren Mittenfrequenzen logarithmisch, also beispielsweise mit Werten von 50 Hz, 200 Hz, 500 Hz, 3,2 KHz, 12,8 KHz, über das Audiofrequenzband verteilt sind. In diesem Falle werden im Speicher die Verstärkungswerte für die Mittenfrequenzen der zu verstellenden Frequenzbänder abgelegt und bei sich ändernderm CD-TOC als der Tonträger-Kennung, beispielsweise in Folge der Auswahl einer neuen CD, an die Klangbeeinflussungseinrichtung 30 übermittelt. In diesem Falle, in dem keine Koeffizienten für digitale Filter, sondern Verstärkungsfaktoren für analoge Bandpässe abgespeichert werden, ist eine Umrechnung der an der Bedieneinheit 60 eingegebenen Stärkungswerte durch die Steuerung 80 nicht erforderlich.

Schließlich ist an die Steuerung 80 eine Anzeigeeinheit 90 angeschlossen, auf der dem Benutzer beim Einstellen des Frequenzganges für einen bestimmten Tonträger die Verstärkungsfaktoren in den einzelnen Frequenzbänder, vorzugsweise graphisch, z. B. in Form eines Histogramms, angezeigt werden.

Figur 2 zeigt schematisch ein Magazin 25 eines an ein Autoradio angeschlossenen CD-Wechslers mit darin eingelegten CDs 21, 22, 23, 24 als Beispiele für verschiedene wiedergebbare Audiosignalträger. Erfindungsgemäß sind bei einem ersten Ausführungsbeispiel der Erfindung die Inhalte TOCs der CDs 21 bis 24 auf den ersten Speicherplätzen 71 bis 74 des Speichers abgelegt, wobei jedem der Speicherplätze 71 bis 74 eine weiterer Speicherplatz 75 bis 78 für einen CD-spezifischen Frequenzgang zugeordnet ist.

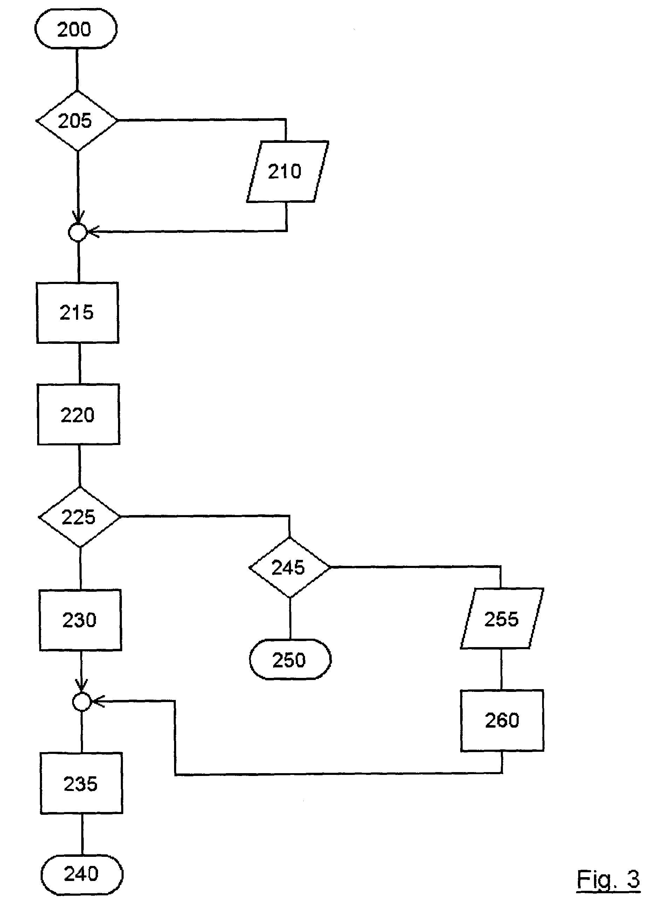

Figur 3 zeigt den Ablauf des erfindungsgemäßen Verfahrens bzw. den in der Steuerung 80 des erfindungsgemäßen Wiedergabegeräts 30 in Form von Software implementierten Ablauf.

Der Ablauf beginnt in Schritt 200, beispielsweise mit dem Einschalten des erfindungsgemäßen Geräts oder der Auswahl eines wiederzugebenden Audiosignalträgers durch den Benutzer. In Schritt 205 wird zunächst geprüft, ob sich ein Audiosignalträger, also beispielsweise eine der CDs 21, 22, 23, 24 aus dem CD-Magazin 25 des CD-Wechslers 25 in Abspielposition befindet, d. h. ob eine der CDs 21 bis 24 ausgewählt und abspielbereit ist. Ist dies nicht der Fall, so geht der Ablauf zu Schritt 210 über, in dem der Benutzer zur Auswahl einer CD aus dem CD-Magazin aufgefordert wird.

Hat der Benutzer eine CD ausgewählt, bzw. war bei Beginn des Ablaufs bereits eine CD in Abspielposition, so geht der Ablauf zu Schritt 215 über, wo die Steuerung 80 die am Ausgang des CD-Wechslers die Kennung, also die anstehenden charakteristischen Informationen der ausgewählten bzw. abspielbereiten CD, also beispielsweise ihren TOC-Inhalt oder gegebenenfalls andere, eine Identifizierung der CD ermöglichende und auf der CD gespeicherte Informationen, einliest und auswertet. Anschließend vergleicht die Steuerung in Schritt 220 die Kennung, also entweder den TOC-Inhalt selbst, oder bei einem anderen Ausführungsbeispiel aus dem TOC-Inhalt abgeleitete charakteristische Informationen, bzw. die anderen zur Identifizierung der CD geeigneten Informationen mit dem Inhalt der ersten Speicherplätze 71, 72, 73, 74 des Speichers. Wird in Schritt 225 eine Übereinstimmung der charakteristischen Informationen, also der Kennung, der aktuell in Abspielposition befindlichen CD mit dem Inhalt eines der ersten Speicherplätze 71 bis 74 festgestellt, so wird aus dem dem betroffenen ersten Speicherplatz 71, 72, 73 oder 74 zugeordneten weiteren Speicherplatz 75, 76, 77 oder 78 die dort gespeicherte Klangcharakteristik, also beispielsweise ein Frequenzgang ausgelesen (230), und der Klangbeeinflussungseinrichtung 30 zugewiesen, die dann eine Beeinflussung des wiedergegebenen Audiosignals entsprechend den zugeführten Parametern bewirkt (Schritt 235). Anschließend endet der erfindungsgemäße Ablauf in Schritt 240.

Wird in Schritt 225 festgestellt, daß zwischen den von der in Abspielposition befindlichen CD gelesenen Informationen und den Informationen auf den ersten Speicherplätzen 71 bis 74 keine Übereinstimmung besteht, so bedeutet dies, daß zu der aktuell ausgewählten CD noch keine Klangcharakteristik auf einem der weiteren Speicherplätze 75 bis 78 vorliegt. In diesem Fall geht der Ablauf zu Schritt 245 über, wo vom Benutzer eine Entscheidung darüber angefordert wird, ob eine Klangcharakteristik eingegeben werden soll, oder nicht. Entscheidet sich der Benutzer gegen die Eingabe einer Klangcharakteristik, so endet der Ablauf in Schritt 250, und die ausgewählte CD wird mit der aktuell an der Klangbeeinflussungseinrichtung 30 eingestellten Klangcharakteristik wiedergegeben.

Entscheidet sich der Benutzer hingegen im Schritt 245 für die Eingabe einer Klangcharakteristik, so geht der Ablauf zu Schritt 255 über, wo der Benutzer, beispielsweise mittels der den einzelnen Frequenzbändern zugeordneten Schiebereglern 66 der Bedieneinheit 60, eine Klangcharakteristik vorgibt. Anschließend werden die für die aktuell ausgewählte CD charakteristischen Informationen, im einfachsten Fall also ihr TOC-Inhalt, auf einem freien der ersten Speicherplätze 71 bis 74 abgelegt und die benutzerdefinierte zugehörige Klangcharakteristik auf dem weiteren Speicherplatz 75 bis 78 abgelegt, der dem ersten Speicherplatz 71 bis 74 zugeordnet ist, auf dem die charakteristischen Informationen der aktuell ausgewählten CD abgelegt worden sind (Schritt 260). Nach Abspeichern der Kennung der aktuell ausgewählten CD und der zugehörigen benutzerdefinierten Klangcharakteristik geht der Ablauf zu Schritt 230 über, wo, wie beschrieben, die Klangcharakteristik zu der aktuell ausgewählten CD aus dem Speicher 70 ausgelesen und schließlich der Klangbeeinflussungseinrichtung 30 zugewiesen wird.

Wie eingangs erwähnt, ist die Erfindung nicht darauf beschränkt, einem bestimmten Audiosignalträger, d.h. einer bestimmten CD bzw. CD-Kennung einen spezifischen Frequenzgang zuzuweisen, vielmehr ist es gemäß einem alternativen Ausführungsbeispiel vorgesehen, daß einer jeden CD eine vollständige, spezifische Klangcharakteristik mit einem spezifischen Frequenzgang und weiteren spezifischen Klangcharakteristika, wie Echo- und/oder Hall-Effekte, zugewiesen wird.

Dazu werden statt der Frequenzgänge im Speicher 70 des erfindungsgemäßen Wiedergabegeräts Datensätze mit sämtlichen für die spezifische Beeinflussung der Klangcharakteristik erforderlichen Informationen abgelegt.

Vorteilhaft wird bei diesem alternativen Ausführungsbeispiel zur Beeinflussung der Audiosignale, also als Klangbeeinflussungseinrichtung 30, ein digitaler Signalprozessor eingesetzt, in dem sich durch eine geeignete Programmierung die gewünschten Klangeffekte auf einfache Art und Weise in Form digitaler Filter darstellen lassen, wobei eine Beeinflussung der Klangeffekte durch einfachen Austausch von Filterkoeffizienten für die digitalen Filter erfolgen kann.

## Patentansprüche

1. Wiedergabegerät für Audiosignalträger, insbesondere plattenförmige optische Audiosignalträger, mit einer steuerbaren Klangbeeinflussungseinrichtung, insbesondere Equalizer oder digitaler Signalprozessor, zur Steuerung der Klangcharakteristik eines wiederzugebenden Audiosignals,
gekennzeichnet durch
- einen Speicher (70) mit ersten Speicherplätzen (71, 72, 73, 74) für die Audiosignalträger kennzeichnende Kennungen und mit weiteren, den ersten Speicherplätzen jeweils zugeordneten Speicherplätzen (75, 76, 77, 78) zum Ablegen von den Audiosignalträgern zugeordneten Klangcharakteristiken, und
- eine Steuerung (80), die in Abhängigkeit des wiederzugebenden Audiosignalträgers aufgrund der dem Audiosignalträger im Speicher zugeordneten Kennung der Klangbeeinflussungseinrichtung (30) die dem Audiosignalträger zugeordnete Klangcharakteristik zuweist.

2. Wiedergabegerät nach Anspruch 1, gekennzeichnet durch eine Bedieneinheit (60), über die durch den Benutzer eine benutzerdefinierte Klangcharakteristik zu einem wiederzugebenden Audiosignalträger eingebbar ist.

3. Wiedergabegerät nach Anspruch 2, dadurch gekennzeichnet, daß die benutzerdefinierte Klangcharakteristik zu einem wiederzugebenden Audiosignalträger auf einem weiteren Speicherplatz (75, 76, 77, 78) des Speichers (70) abspeicherbar ist.

4. Verfahren zur Beeinflussung einer Klangcharakteristik eines wiederzugebenden Audiosignals von einem Audiosignalträger, insbesondere einem plattenförmigen optischen Audiosignalträger, mittels einer steuerbaren Klangbeeinflussungseinrichtung,
dadurch gekennzeichnet,
daß in Anhängigkeit des jeweils wiederzugebenden Audiosignalträgers der Klangbeeinflussungseinrichtung (30) eine im Speicher (70) abgespeicherte, dem wiederzugebenden Audiosignalträger zugeordnete, Klangcharakteristik zugewiesen wird.
